# EUROPÄISCHE PATENTSCHRIFT

(11) **EP 1 245 137 B1**
(45) Veröffentlichungstag und Bekanntmachung des Hinweises auf die Patenterteilung: **04.06.2003**
(21) Anmeldenummer: 00981136.5
(22) Anmeldetag: 29.09.2000
(51) Int. Cl.: H05K 3/00, B23K 26/00

(54) **VERFAHREN UND EINRICHTUNG ZUM LASERBOHREN VON ORGANISCHEN MATERIALIEN**
METHOD AND DEVICE FOR LASER DRILLING ORGANIC MATERIALS
PROCEDE ET DISPOSITIF DE PER AGE AU LASER DE MATIERES ORGANIQUES

(30) Priorität: 30.09.1999 DE 19947040
(43) Veröffentlichungstag der Anmeldung: 02.10.2002
(73) Patentinhaber: SIEMENS AKTIENGESELLSCHAFT, 80333 München (DE)
(72) Erfinder: DE STEUR, Hubert, B-9031 Drongen (BE); HEERMAN, Marcel, B-9200 Merelbeke (BE); VAN PUYMBROECK, Jozef, B-8020 Oostkamp (BE)
(86) Internationale Anmeldenummer: DE0003426
(87) Internationale Veröffentlichungsnummer: WO01026436

(56) Entgegenhaltungen:
- DE-A- 19 719 700
- DE-A- 19 824 225
- GB-A- 2 338 201
- US-A- 4 839 497
- US-A- 5 593 606
- T.R. FLETCHER: "EFFICIENT ABLATION OF AN ORGANIC POLYMER BY A LASER DRIVEN SHOCK WAVE" JOURNAL OF APPLIED PHYSICS, Bd. 73, Nr. 10, 15. Mai 1993 (1993-05-15), Seiten 5292-5294, XP002159626 New York, USA
- MAKROPOULOU M I ET AL: "VIS AND UV LASER ABLATION OF POLYMERS" SECOND GR-I INTERNATIONAL CONFERENCE ON NEW LASER TECHNOLOGIES AND APPLICATIONS, OLYMPIA, GREECE, 1-4 JUNI 1997, PROCEEDINGS OF THE SPIE, Bd. 3423, 1998, Seiten 384-388, XP000866592 The International Society for Optical Engineering, USA
- "WIRESTRIPPING PROCEDURE USING VISIBLE LASER RADIATION AND DYE-DOPED INSULATION" IBM TECHNICAL DISCLOSURE BULLETIN,US,IBM CORP. NEW YORK, Bd. 34, Nr. 12, 1. Mai 1992 (1992-05-01), Seite 378 XP000308558 ISSN: 0018-8689

## Beschreibung

Aus der EP-A-0 164 564 ist es bekannt, in einem Laminat mit der Schichtenfolge Metall-Dielektrikum-Metall mit Hilfe eines Excimer-Lasers Sacklöcher zu erzeugen. Die oberste Metallschicht des Laminats wird hierbei als Lochmaske verwendet, deren Lochbild mittels Phototechnik übertragen und durch nachfolgendes Ätzen hergestellt wird. Das im Lochbereich dieser Maske freiliegende Dielektrikum wird dann durch die Einwirkung des Excimer-Lasers abgetragen, bis die unterste Metallschicht erreicht ist und den Abtragungsprozess beendet. Mit dem bekannten Verfahren werden insbesondere bei der Herstellung mehrlagiger Leiterplatten die erforderlichen Durchkontaktierungslöcher in Form von Sacklöchern hergestellt.

Aus der DE-Z "Feinwerktechnik & Messtechnik 91 (1983) 2, S. 56-58 ist ein ähnliches Verfahren zur Herstellung mehrlagiger Leiterplatten bekannt, bei welchem die als Durchkontaktierungen dienenden Sacklöcher mit Hilfe eines CO₂-Lasers erzeugt werden. Auch hier dient die oberste Kupferfolie als Lochmaske, bei der überall dort, wo der Laserstrahl ein Loch erzeugen soll, das Kupfer weggeätzt wird.

Aus der DE-A-197 19 700 sind auch bereits Einrichtungen zum Laserbohren von Laminaten bekannt, bei welchen zum Bohren der Metallschichten ein erster Laser mit einer Wellenlänge im Bereich von etwa 266 nm bis 1064 nm und zum Bohren der Dielektrikumsschichten ein zweiter Laser mit einer Wellenlänge im Bereich von etwa 1064 nm bis 10600 nm eingesetzt werden.

Aus der US-A-5 593 606 ist ein Verfahren zum Laserbohren von Laminaten bekannt, bei welchem zum Bohren der Metallschichten und zum Bohren der Dielektrikumsschichten ein einziger UV-Laser eingesetzt wird, dessen Wellenlängen unter 400 nm liegen und dessen Pulsbreiten unter 100 ns liegen. Unter der Voraussetzung, dass kein Excimer-Laser verwendet wird, werden also Metall und organisches Material mit dem gleichen UV-Laser gebohrt.

Aus der DE-A-198 24 225 ist ein weiteres Verfahren zum Laserbohren von Laminaten bekannt, bei welchem zum Bohren der Metallschichten und zum Bohren der Dielektrikumsschichten beispielsweise auch ein SHG (zweite harmonische Generation)-YAG-Laser mit einer Wellenlänge von 532 nm oder ein THG (dritte harmonische Generation)-YAG-Laser mit einer Wellenlänge von 355 nm eingesetzt werden können.

Grundsätzlich kann festgestellt werden, dass beim Laserbohren von organischen Materialien mit UV-Lasern, das heißt mit Wellenlängen unterhalb 400 nm, eine photochemische Zersetzung der organischen Materialien stattfindet. Hier kommt es also zu keinen Verbrennungen und aufgrund der allenfalls äußerst geringen thermischen Belastung kommt es bei Laminaten zu keiner Delamination. Im Gegensatz dazu findet beim Laserbohren von organischen Materialien mit CO₂-Lasern eine thermische Zersetzung der organischen Materialien statt, das heißt es kann zu Verbrennungen kommen und bei Laminaten besteht die Gefahr einer Delamination. Im Vergleich zu UV-Lasern können mit CO₂-Lasern beim Bohren von organischen Materialien jedoch erheblich kürzere Bearbeitungszeiten erzielt werden.

Aus der EP-A-0 478 313 ist das sogenannte SLC-Verfahren (Surface Laminar Circuit) bekannt, bei welchem zunächst auf einem Basissubstrat eine erste Verdrahtungsebene erzeugt wird. Auf diese erste Verdrahtungsebene wird dann durch Siebdruck oder durch Vorhanggießen eine dielektrische Schicht aus einem fotoempfindlichen Expoxidharz aufgebracht. Auf fotolithografischem Wege durch Belichten und Entwickeln werden dann in der dielektrischen Schicht Sacklöcher hergestellt. Nach dem chemischen und galvanischen Verkupfern der Lochwände und der Oberfläche der dielektrischen Schicht wird die zweite Verdrahtungsebene durch Strukturierung der abgeschiedenen Kupferschicht erzeugt. Durch alternierendes Aufbringen von fotoempfindlichen dielektrischen Schichten und Kupferschichten können dann in der geschilderten Weise weitere Verdrahtungsebenen hergestellt werden.

Der in den Ansprüchen 1 und 13 angegebenen Erfindung liegt das Problem zugrunde, beim Laserbohren von organischen Materialien eine rasche Herstellung von Sack- oder Durchgangslöchern ohne thermische Schädigung des Materials zu ermöglichen.

Der Erfindung liegt die Erkenntnis zugrunde, dass mit frequenzverdoppelten Nd-Vanadate-Lasern mit einer Wellenlänge von 532 nm bei kurzen Pulsbreiten unter 40 ns Schichten aus organischem Material bei kurzen Bearbeitungszeiten und ohne die Gefahr von Verbrennungen bearbeitet werden können. Dabei werden für das Laserbohren des organischen Materials Pulsfrequenzen ≥ 20 kHz gewählt. Bei der Laserbearbeitung der organischen Materialien ergibt sich eine Kombination von photochemischer und thermischer Zersetzung, die im Vergleich zu UV-Lasern kürzere Bearbeitungszeiten ermöglicht und im Vergleich zu CO₂-Lasern zu hohe thermische Belastungen vermeidet. Ein weiterer Vorteil ist darin zu sehen, dass mit dem gleichen Nd-Vanadate-Laser auch Metallschichten von Laminaten gebohrt werden können. Für das Bohren derartiger Metallschichten werden dann Pulsfrequenzen ≥ 30 kHz gewählt.

Der für das Bohren von organischen Materialien erfindungsgemäß ausgewählte frequenzverdoppelte ND-Vanadate-Laser ermöglicht sehr hohe Pulsfrequenzen, die sogar über 100 kHz liegen können bei geringen Pulsbreiten von weniger als 40 ns. Die hohen Pulsfrequenzen ermöglichen dabei eine rasche und effektive Bearbeitung der organischen Materialien, während durch die niedrigen Pulsbreiten eine sehr niedrige thermische Belastung gewährleistet wird. Mit anderen Lasern, die mit ähnlichen oder gleichen Wellenlängen arbeiten, kann eine derartige Kombination von hohen Pulsfrequenzen und kurzen Pulsbreiten nicht realisiert werden. So können beispielsweise bei dem aus der DE-A-198 24 225 bekannten SHG-YAG-Laser bei höheren Pulsfrequenzen allenfalls Pulsbreiten von 70 bis 80 ns erzielt werden.

Vorteilhafte Ausgestaltungen des erfindungsgemäßen Verfahrens gehen aus den Ansprüchen 2 bis 12 hervor.

Die Ausgestaltung nach Anspruch 2 ermöglicht durch Pulsbreiten von weniger als 30 ns eine noch geringere thermische Belastung der organischen Materialien oder ggf. der Laminate beim Laserbohren.

Bei Verwendung eines fokussierten Laserstrahls mit einem Spotdurchmesser zwischen 10 µm und 100 µm gemäß Anspruch 3 ergibt sich eine effektive Laserbearbeitung der organischen Materialien. Bei Verwendung von Spotdurchmessern zwischen 20 µm und 50 µm gemäß Anspruch 4 kann die Laserbearbeitung der organischen Materialien noch effektiver gestaltet werden.

Die Ausgestaltung nach Anspruch 5 ermöglicht durch die höhere Absorption der Laserstrahlen im organischen Material eine erhebliche Steigerung der Bearbeitungsgeschwindigkeit. Die Zusatzstoffe sollen dabei einen deutlich höheren Absorptionsgrad für Laserstrahlen mit einer Wellenlänge von 532 nm aufweisen als das reine organische Material.

Die Weiterbildung nach Anspruch 6 ermöglicht eine besonders einfache und wirtschaftliche Steigerung des Absorptionsgrades des organischen Materials.

Die Ausgestaltung nach Anspruch 7 ermöglicht durch die Auswahl von roten Zusatzstoffen eine Optimierung des Absorptionsgrades, da das grüne Licht der Wellenlänge 532 nm durch die Komplementärfarbe Rot besonders gut absorbiert wird.

Die Weiterbildung nach Anspruch 8 gibt für die Beimengung von Pigmenten als Zusatzstoff einen Mengenbereich an, der sich zur Steigerung des Absorptionsgrades ohne Beeinträchtigung der sonstigen Eigenschaften besonders gut bewährt hat. Der in Anspruch 9 angegebene engere Mengenbereich ist dabei als optimal anzusehen.

Wird der Absorptionsgrad des organischen Materials durch die Beimengung von Zusatzstoffen gemäß Anspruch 10 auf mindestens 50 % gesteigert, so ergibt sich bereits eine beträchtliche Steigerung der Bearbeitungsgeschwindigkeit im organischen Material. Bei einer Steigerung des Absorptionsgrades auf mindestens 60 % gemäß Anspruch 11 bzw. auf mindestens 80% gemäß Anspruch 12 können die Bearbeitungszeiten für das Laserbohren des organischen Materials entsprechend weiter verringert werden.

In den nachfolgend beschriebenen Beispielen wurden die folgenden Lasertypen eingesetzt:

| Laser I: | |
|---|---|
| Diodengepumpter, frequenzverdoppelter Nd-Vanadate-Laser der Firma Spectra Physics, Mountain View, California, US. | |
| Bezeichnung | T80-YHP40-532QW |
| Wellenlänge | 532 nm |
| Leistung | ca. 8,5 W |
| Betriebsart | Monomode TEMoo |
| Pulsbreite | 20 ns bei Pulsfrequenz 10 kHz |
| Pulsfrequenz | bis 200 kHz |
| Feldgröße | 100x100 mm². |

| Laser II: | |
|---|---|
| Diodengepumpter, frequenzverdoppelter Nd-Vanadate-Laser der Firma Haas-Laser GmbH, Schramberg, DE. | |
| Bezeichnung | keine, da Prototype |
| Wellenlänge | 532 nm |
| Leistung | ca. 4,0 W |
| Betriebsart | Monomode TEMoo |
| Pulsbreite | 25 ns bei Pulsfrequenz 10 kHz |
| Pulsfrequenz | bis 200 kHz. |
| Feldgröße | 100x100 mm². |

### Beispiel 1:

Bei der Herstellung von Mehrlagenverdrahtungen werden auf die bereits fertig ausgebildeten Verdrahtungslagen durch Vorhanggießen oder durch Siebdruck dielektrische Schichten aus einem organischen Material in einer Stärke von beispielsweise 25 µm aufgebracht. Als organisches Material ist beispielsweise ein Epoxy-Material geeignet. In diese dielektrischen Schichten werden dann ohne Verwendung von Masken Sacklöcher eingebracht, die später als Durchkontaktierungen zu den nächsten Verdrahtungslagen dienen.

Zum Einbringen von Sacklöchern in die dielektrischen Schichten wurde der Laser II eingesetzt. Bei Verwendung von zwei Galvanometerspiegeln zur Ablenkung des Laserstrahls kann eine Fläche von 10 cm x 10 cm bearbeitet werden. Weitere Parameter des Lasers werden wie folgt angegeben:

| | |
|---|---|
| Pulsbreite | 30 ns |
| Pulsfrequenz | 25 kHz |

Mit einem Spotdurchmesser des fokussierten Laserstrahls von ca. 25 µm wurden die Sacklöcher an den vorgegebenen Stellen in die dielektrischen Schichten eingebracht. Dabei wurde eine Pulsfrequenz zwischen 10 und 20 kHz gewählt. Verbrennungen oder andere thermische Schädigungen konnten bei dem Einbringen der Sacklöcher vermieden werden.

### Beispiel 2:

Mit dem Laser I wurden in das Epoxy-Material eines RCC-Materials (RCC = Resin Coated Copper Foil) Sacklöcher mit einem Durchmesser von 125 um eingebracht. Das RCC-Material bestand aus einer 12 µm starken Kupferfolie und einer 60 µm starken Dielektrikums-Schicht aus Epoxy-Material. Die Pulsfrequenz betrug 25 kHz. Die Pulslänge betrug 30 ns.

Bei Verwendung von zwei Galvanometerspiegeln zur Ablenkung des Laserstrahls in X-Richtung und in Y-Richtung wurde eine Fläche von 10cm x 10 cm bearbeitet. Zum Bohren des Epoxy-Materials wurde der Laserstrahl 1,6 mm außer Fokus gestellt (OOF = Out of Focus) und in konzentrischen Kreisen im Lochbereich bewegt. Die Lineargeschwindigkeit des Laserstrahls betrug 900 mm/s. Nach dem Durchbohren des Epoxy-Materials wurde die darunterliegende Kupferschicht nur geringfügig angegriffen.

Das Bohren des Epoxy-Materials erfolgte mit einer Geschwindigkeit von 220 Löchern pro Sekunde.

### Beispiel 3:

Abweichend vom Beispiel 2 wurde der Laser II mit den gleichen Laserparametern eingesetzt. Das Bohren des Epoxy-Materials erfolgte mit einer Geschwindigkeit von 122 Löchern pro Sekunde.

### Beispiel 4:

Abweichend vom Beispiel 2 wurden die Sacklöcher in ein 60 µm starkes FR4-Material (FR4 = level4 fire retardant epoxy-glass composition) eingebracht, auf welches einseitig eine 12 µm starke Kupferfolie auflaminiert war. Die Ergebnisse waren vergleichbar.

### Beispiel 5:

Abweichend vom Beispiel 3 wurden die Sacklöcher in ein 60 µm starkes FR4-Material eingebracht, auf welches einseitig eine 12 um starke Kupferfolie auflaminiert war. Die Ergebnisse waren vergleichbar.

### Beispiel 6:

Abweichend vom Beispiel 2 wurden Sacklöcher mit einem Durchmesser von 100 µm hergestellt. Das Bohren des Epoxy-Materials erfolgte hier mit einer Geschwindigkeit von 382 Löchern pro Sekunde.

### Beispiel 7:

Abweichend vom Beispiel 3 wurden Sacklöcher mit einem Durchmesser von 100 µm hergestellt. Das Bohren des Epoxy-Materials erfolgte hier mit einer Geschwindigkeit von 212 Löchern pro Sekunde.

### Beispiel 8:

Abweichend vom Beispiel 2 wurden Sacklöcher mit einem Durchmesser von 75 µm hergestellt. Das Bohren des Epoxy-Materials erfolgte hier mit einer Geschwindigkeit von 800 Löchern pro Sekunde.

### Beispiel 9:

Abweichend vom Beispiel 3 wurden Sacklöcher mit einem Durchmesser von 75 µm hergestellt. Das Bohren des Epoxy-Materials erfolgte hier mit einer Geschwindigkeit von 400 Löchern pro Sekunde.

### Beispiel 10:

Abweichend vom Beispiel 2 wurde ein modifiziertes Epoxy-Material verwendet, welchem ca. 1,5 Gew.-% eines Zusatzstoffes beigemengt wurde. Bei dem Zusatzstoff handelte es sich um ein organisches rotes Pigment mit der Bezeichnung "1501 Fast Red" (C.I. Pigment Red 48:1) der Firma Xijingming, Shenzhou City, Hebei Province, P.R. China. Dieses Pigment ist ein Azo-Pigment auf der Basis eines Bariumsalzes. Die Geschwindigkeit für das Bohren des Epoxy-Materials konnte durch die verbesserte Absorption der Laserstrahlung auf 550 Löcher pro Sekunde gesteigert werden.

### Beispiel 11:

Abweichend vom Beispiel 10 wurde als Zusatzstoff ein anorganisches rotes Pigment mit der Bezeichnung "Bayferrox™" (C.I. Pigment Rot 101) der Bayer AG, DE verwendet. Dieses Pigment ist ein Eisenoxidrotpigment. Die Ergebnisse waren vergleichbar.

### Beispiel 12:

Abweichend vom Beispiel 10 wurde als Zusatzstoff ein polymerlöslicher Antrachinon-Farbstoff mit der Bezeichnung "Oracet™ Gelb GHS (C.I. Solvent Gelb 163) der CIBA-GEIGY AG, CH verwendet. Die Steigerung der Geschwindigkeit für das Bohren des Epoxy-Materials fiel hier etwas geringer aus.

### Beispiel 13:

Abweichend vom Beispiel 10 wurde der Laser II mit den gleichen Laserparametern eingesetzt. Die Geschwindigkeit für das Bohren des Epoxy-Materials konnte auf 306 Löcher pro Sekunde gesteigert werden.

### Beispiel 14:

Abweichend vom Beispiel 10 wurden Sacklöcher mit einem Durchmesser von 100 µm hergestellt. Die Geschwindigkeit für das Bohren des Epoxy-Materials betrug 956 Löcher pro Sekunde.

### Beispiel 15:

Abweichend vom Beispiel 13 wurden Sacklöcher mit einem Durchmesser von 100 µm hergestellt. Die Geschwindigkeit für das Bohren des Epoxy-Materials betrug 531 Löcher pro Sekunde.

### Beispiel 16:

Abweichend vom Beispiel 4 wurde ein modifiziertes FR4-Material verwendet, bei welchem das Epoxy-Material anstelle der üblichen Glasfaserverstärkung mit ca. 50 Gew.-% Fasern eines Rubinglases verstärkt war. Dieses Rubinglas wurde durch Zu satz von 2 Gew.-% Selen, 1 Gew.-% Arsentrioxid und 0,5 Gew.-% Kohle zu einem Grundglas der Zusammensetzung Na₂O-ZnO-4SIO₂ hergestellt. Die Geschwindigkeit für das Bohren dieses glasverstärkten Epoxy-Materials konnte um einen Faktor zwischen 2 und 2,5 gesteigert werden.

## Patentansprüche

1. Verfahren zum Laserbohren von organischen Materialien, **gekennzeichnet durch** die Verwendung eines frequenzverdoppelten Nd-Vanadate-Lasers mit folgenden Laserparametern:
- Pulsbreite < 40 ns
- Pulsfrequenz ≥ 20 kHz
- Wellenlänge = 532 nm.

2. Verfahren nach Anspruch 1, **dadurch gekennzeichnet, dass** eine Pulsbreite < 30 ns verwendet wird.

3. Verfahren nach Anspruch 1 oder 2, **dadurch gekennzeichnet, dass** ein fokussierter Laserstrahl mit einem Spotdurchmesser zwischen 10 µm und 100 µm verwendet wird.

4. Verfahren nach Anspruch 3, **dadurch gekennzeichnet, dass** ein fokussierter Laserstrahl mit einem Spotdurchmesser zwischen 20 µm und 40 µm verwendet wird.

5. Verfahren nach einem der vorhergehenden Ansprüche, **dadurch gekennzeichnet, dass** dem organischen Material Zusatzstoffe beigemengt werden, die einen höheren Absorptionsgrad für Laserstrahlen mit einer Wellenlänge von 532 nm aufweisen als das reine organische Material.

6. Verfahren nach Anspruch 5, **dadurch gekennzeichnet, dass** als Zusatzstoff mindestens ein anorganisches und/oder organisches Pigment und/oder mindestens ein polymerlöslicher Farbstoff und/oder mindestens ein faserförmiger Füllstoff verwendet wird.

7. Verfahren nach Anspruch 6, **dadurch gekennzeichnet, dass** als Zusatzstoff mindestens ein anorganisches rotes Pigment und/oder ein organisches rotes Pigment und/oder ein polymerlöslicher roter Farbstoff verwendet wird.

8. Verfahren nach Anspruch 6 oder 7, **dadurch gekennzeichnet, dass** dem organischen Material zwischen 0,1 Gew.-% und 5,0 Gew.-% Pigmente beigemengt werden.

9. Verfahren nach Anspruch 6 oder 7, **dadurch gekennzeichnet, dass** dem organischen Material zwischen 1 Gew.-% und 2 Gew.-% Pigmente beigemengt werden.

10. Verfahren nach einem der Ansprüche 5 bis 9, **dadurch gekennzeichnet, dass** das organische Material durch die Beimengung der Zusatzstoffe einen Absorptionsgrad von mindestens 50 % für die Wellenlänge 532 nm der Laserstrahlung aufweist.

11. Verfahren nach einem der Ansprüche 5 bis 9, **dadurch gekennzeichnet, dass** das organische Material durch die Beimengung der Zusatzstoffe einen Absorptionsgrad von mindestens 60 % für die Wellenlänge 532 nm der Laserstrahlung aufweist.

12. Verfahren nach einem der Ansprüche 5 bis 9, **dadurch gekennzeichnet, dass** das organische Material durch die Beimengung der Zusatzstoffe einen Absorptionsgrad von mindestens 80 % für die Wellenlänge 532 nm der Laserstrahlung aufweist.

13. Einrichtung zum Laserbohren von organischen Materialien, mit einem frequenzverdoppelten Nd-Vanadate-Laser mit folgenden Laserparametern:
- Pulsbreite < 40 ns
- Pulsfrequenz ≥ 20 kHz
- Wellenlänge = 532 nm.

## Claims

1. Method for the laser drilling of organic materials, **characterized by** the use of a frequency-doubled Nd-vanadate laser with the following laser parameters:
- pulse width < 40 ns
- pulse frequency ≥ 20 kHz
- wavelength = 532 nm.

2. Method according to Claim 1, **characterized in that** a pulse width of < 30 ns is used.

3. Method according to Claim 1 or 2, **characterized in that** a focused laser beam with a spot diameter of between 10 µm and 100 µm is used.

4. Method according to Claim 3, **characterized in that** a focused laser beam with a spot diameter of between 20 µm and 40 µm is used.

5. Method according to one of the preceding claims, **characterized in that** additives which have a higher degree of absorption for laser beams with a wavelength of 532 nm than the pure organic material are admixed with the organic material.

6. Method according to Claim 5, **characterized in that** at least one inorganic and/or organic pigment and/or at least one polymer-soluble dye and/or at least one fibrous filler is used as the additive.

7. Method according to Claim 6, **characterized in that** at least one inorganic red pigment and/or one organic red pigment and/or one polymer-soluble red dye is used as the additive.

8. Method according to Claim 6 or 7, **characterized in that** between 0.1% by weight and 5.0% by weight of pigments are admixed with the organic material.

9. Method according to Claim 6 or 7, **characterized in that** between 1% by weight and 2% by weight of pigments are admixed with the organic material.

10. Method according to one of Claims 5 to 9, **characterized in that** the organic material has as a result of the admixing of the additives a degree of absorption of at least 50% for the wavelength 532 nm of the laser radiation.

11. Method according to one of Claims 5 to 9, **characterized in that** the organic material has as a result of the admixing of the additives a degree of absorption of at least 60% for the wavelength 532 nm of the laser radiation.

12. Method according to one of Claims 5 to 9, **characterized in that** the organic material has as a result of the admixing of the additives a degree of absorption of at least 80% for the wavelength 532 nm of the laser radiation.

13. Device for the laser drilling of organic materials, with a frequency-doubled Nd-vanadate laser with the following laser parameters:
- pulse width < 40 ns
- pulse frequency ≥ 20 kHz
- wavelength = 532 nm.

## Revendications

1. Procédé de perçage au laser de matières organiques, **caractérisé par** l'utilisation d'un laser vanadate Nd double fréquence dont les paramètres laser sont les suivants:
- durée d'impulsion < 40 ns,
- fréquence de pulsation ≥ 20 kHz,
- longueur d'onde = 532 nm.

2. Procédé selon la revendication 1, **caractérisé par** l'utilisation d'une durée d'impulsion < 30 ns.

3. Procédé selon la revendication 1 ou 2, **caractérisé par** l'utilisation d'un rayon laser focalisé, le diamètre de focalisation étant compris entre 10 µm et 100 µm.

4. Procédé selon la revendication 3, **caractérisé par** l'utilisation d'un rayon laser focalisé, le diamètre de focalisation étant compris entre 20 µm et 40 µm.

5. Procédé selon l'une des revendications précédentes, **caractérisé par** l'adjonction d'adjuvants à la matière organique, lesquels présentent un degré d'absorption de rayons laser, ayant une longueur d'onde de 532 nm, supérieur à celui de la matière organique pure.

6. Procédé selon la revendication 5, **caractérisé par** l'utilisation, en tant qu'adjuvant, d'au moins un pigment inorganique et/ou organique et/ou d'au moins un colorant soluble dans des polymères et/ou d'au moins une matière de charge se présentant sous forme de fibres.

7. Procédé selon la revendication 6, **caractérisé par** l'utilisation, en tant qu'adjuvant, d'au moins un pigment rouge inorganique et/ou d'un pigment rouge organique et/ou d'un colorant rouge soluble dans des polymères.

8. Procédé selon la revendication 6 ou 7, **caractérisé par** l'adjonction de pigments à la matière organique, comprise entre 0,1% en poids et 5% en poids de pigments.

9. Procédé selon la revendication 6 ou 7, **caractérisé par** l'adjonction de pigments à la matière organique, comprise entre 1% en poids et 2 % en poids de pigments.

10. Procédé selon l'une des revendications 5 à 9, **caractérisé en ce que** la matière organique présente, suite à l'adjonction des adjuvants, un degré d'absorption d'au moins 50% pour la longueur d'onde de 532 nm du rayonnement laser.

11. Procédé selon l'une des revendications 5 à 9, **caractérisé en ce que** la matière organique présente, suite à l'adjonction des adjuvants, un degré d'absorption d'au moins 60% pour la longueur d'onde de 532 nm du rayonnement laser.

12. Procédé selon l'une des revendications 5 à 9, **caractérisé en ce que** la matière organique présente, suite à l'adjonction des adjuvants, un degré d'absorption d'au moins 80% pour la longueur d'onde de 532 nm du rayonnement laser.

13. Dispositif pour percer des matières organiques au laser avec un laser vanadate Nd double fréquence dont les paramètres laser sont les suivants:
- durée d'impulsion < 40 ns,
- fréquence de pulsation ≥ 20 kHz,
- longueur d'onde = 532 nm.
